Europäisches Patentamt

European Patent Office

Office européen des brevets

(11) Veröffentlichungsnummer: **0 258 818**
A2

(12) **EUROPÄISCHE PATENTANMELDUNG**

(21) Anmeldenummer: 87112441.8

(51) Int. Cl.⁴: **B01J 6/00** , C01B 33/02

(22) Anmeldetag: 27.08.87

(30) Priorität: 28.08.86 DE 3629231

(43) Veröffentlichungstag der Anmeldung:
09.03.88 Patentblatt 88/10

(84) Benannte Vertragsstaaten:
DE FR GB IT

(71) Anmelder: HELIOTRONIC Forschungs- und Entwicklungsgesellschaft für Solarzellen-Grundstoffe mbH
Johannes-Hess-Strasse 24
D-8263 Burghausen(DE)

(72) Erfinder: Dietl, Josef, Dr. Dipl.-Phys.
Am Bärenbach 17
D-8262 Neuötting(DE)
Erfinder: Kotilge, Jörg, Dipl.-Ing.
Hartmannstrasse 13
D-8261 Mehring-Öd(DE)

(54) Verfahren zum Aufschmelzen von in einen Schmelztiegel chargiertem Siliciumpulver und Schmelztiegel zur Durchführung des Verfahrens.

(57) Es wird ein Verfahren zum kontinuierlichen oder portionsweisen Aufschmelzen von Siliciumpulver, insbesondere mit hohem Feinanteil, sowie ein Schmelztiegel zur Durchführung dieses Verfahrens angegeben. Im Schmelztiegel wird dabei vorteilhaft ein eine bestimmte Mindesthöhe aufweisender Schmelzsee vorgesehen, der von nicht aufgeschmolzenem Siliciumpulver überlagert ist. Das nachchargierte Material kommt somit zuerst mit bereits vorliegendem Siliciumpulver in Kontakt und gelangt erst nach und nach in die Schmelzzone. Die hier erzeugte, die Mindesthöhe des Schmelzsees übersteigende Schmelzenmenge fließt aus dem Schmelztiegel ab. Vorteilhaft wird das Verfahren in Schmelztiegeln durchgeführt, die im Boden einen siphonartigen Abfluß aufweisen.

EP 0 258 818 A2

## Verfahren zum Aufschmelzen von in einen Schmelztiegel chargiertem Siliciumpulver und Schmelztiegel zur Durchführung des Verfahrens

Die Erfindung betrifft ein Verfahren zum Aufschmelzen von in einen Schmelztiegel chargiertem Siliciumpulver und Schmelztiegel zur Durchführung dieses Verfahrens.

Die Erzeugung von Schmelzen aus Siliciumpulver oder -staub ist bekanntermaßen schwierig, insbesondere wenn Fraktionen mit einem hohen Anteil an Partikeln mit einer unter 1 mm liegenden Korngröße beteiligt sind. Solche feinkörnigen Pulverfraktionen fallen beispielsweise beim Zersägen von Siliciumstäben oder -blöcken, beim Zerbrechen oder Zermahlen von in Stabform abgeschiedenem polykristallinen Silicium oder bei der Siliciumabscheidung nach dem Wirbelschichtverfahren in großen Mengen an. Beispielsweise kann gemäß der DE-PS 27 06 175 bzw. der entsprechenden US-PS 41 51 264 Siliciumfeinststaub, der beim Zermahlen von Siliciumbrocken als Abfallprodukt anfällt, in einer mit Kupfer versetzten Silicatschlacke mit Erfolg aufgeschmolzen werden. Das dabei erhaltene Silicium kommt jedoch schon wegen des aufgenommenen Kupferanteils für Anwendungen nicht mehr in Frage, bei denen eine hohe Reinheit gefordert ist. Überdies entstehen durch den Bedarf an Schlacke und die großvolumigen Schmelztiegel, die wegen der neben dem Silicium aufzuschmelzenden großen zusätzlichen Materialmengen erforderlich sind, zusätzliche Kosten.

Gemäß einem anderen gebräuchlichen Aufschmelzverfahren wird ein Schmelztiegel jeweils mit Siliciumpulver möglichst vollständig gefüllt und diese Charge dann niedergeschmolzen. Wegen der gegenüber geschmolzenem Silicium erheblich geringeren Dichte von Siliciumpulver ergibt sich dabei letztendlich ein vergleichsweise geringer Füllgrad des Schmelztiegels, welcher wiederum zur Aufnahme des voluminösen Ausgangsmaterials auf ein großes Fassungsvermögen ausgelegt sein muß. Daraus ergibt sich auch durch die mit wachsendem Tiegelvolumen immer stärkere für die Erzeugung einer Schmelze nötige Tiegelüberhitzung eine zunehmend ungünstige Energieausnutzung und erhöhte Tiegelkorrosion.

Darüber hinaus ist es auch äußerst schwierig, in die solchermaßen erzeugte Schmelze weiter Siliciumpulver zu chargieren, um den Füll grad zu verbessern. Wegen der im Regelfall die Pulverpartikel bedeckenden Oxidhaut kommt es nämlich in diesem Fall durch Reaktion mit der Schmelze unweigerlich zu einer heftigen Freisetzung von Siliciummonoxid, durch die nicht selten der gesamte Tiegelinhalt aus dem Tiegel geschleudert werden kann.

Den genannten Schwierigkeiten begegnete man bisher in vielen Fällen dadurch, daß zum Aufschmelzen vorgesehenes Siliciumpulver erst in einem aufwendigen Klassierungsschritt von dem - schwierig handzuhabenden Feinanteil befreit und dieser, ein an sich wertvoller Rohstoff, verworfen wurde.

Aufgabe der Erfindung war es daher, ein Verfahren anzugeben, welches ein insbesondere kontinuierliches Aufschmelzen von Siliciumpulver, vor allem mit hohem Feinanteil, ermöglicht und dabei die erwähnten Nachteile vermeidet.

Gelöst wird die Aufgabe durch ein Verfahren, welches dadurch gekennzeichnet ist, daß die im Schmelztiegel vorgelegte Pulverschüttung während des Schmelzvorganges stets von einer Schicht nicht angeschmolzenen Siliciumpulvers bedeckt gehalten wird, wobei weiteres Siliciumpulver kontinuierlich oder taktweise auf die vorhandene Schicht nicht angeschmolzenen Siliciumpulvers nachchargiert wird, während nur die durch den in die Schmelzzone nachrückenden Teil der Pulverschüttung erzeugte Siliciumschmelze aus dem Tiegel abgeführt wird.

Durch diese Vorgehensweise wird das nachchargierte Siliciumpulver bereits nach und nach von der anhaftenden Oxidhaut befreit, während es allmählich bis in den Schmelzbereich nachrückt, so daß bei seinem Eintauchen in die Schmelzzone und beim Aufschmelzen das Oxid weitestgehend entfernt ist und keine heftigen Reaktionen mehr zu befürchten sind.

Das Verfahren eignet sich grundsätzlich auch für das Aufschmelzen von grobstückigem Silicium. Mit besonderem Vorteil wird es jedoch bei Siliciumpulvern eingesetzt, die wegen des hohen Feinanteils auf herkömmliche Weise nicht oder nur nach dessen Abtrennung aufgeschmolzen werden können. Solche Pulver fallen beim Zermahlen oder Zerbrechen beispielsweise von Rohsilicium oder von in Rohr-oder Stabform abgeschiedenem polykristallinem Silicium, bei der Abscheidung von Reinstsilicium auf feinen Siliciumpartikeln im Wirbelschichtreaktor, bei der ggf. mit einer zu kontinuierlicher Kornverkleinerung führenden mechanischen Behandlung verbundenen oder ggf. in einer Kammerfilterpresse durchgeführten Säureauslaugung von Siliciumgranulat oder beim Zersägen von Siliciumstäben oder -blöcken an. Erfahrungsgemäß ist bei diesen Pulvern das Aufschmelzen um so schwieriger zu beherrschen, in je höherem Maße sie einen Feinkornanteil aufweisen, der ein Sieb mit einer Maschenweite von etwa 1 mm passiert. Dabei können bereits ab einem Anteil von etwa 1 Gew.-% dieser Fraktion an der gesamten Siliciummenge, große Schwierigkeiten auftreten. Dies gilt insbesondere für den extrem - schwierig aufzuschmelzenden Sägeschlamm, der größtenteils aus Körnern besteht, welche ein Sieb mit Maschenweite 5 μm passieren, oder für das in Schwing-oder Luftstrahlmühlen zerkleinerte, säuregereinigte Silicium, welches als Ausgangsmaterial für Solarzellen geeignet ist und einen hohen Anteil an Partikeln aufweist, die ein Sieb mit Maschenweite 70 μm passieren. Selbst solche bisher einem kontrollierten Aufschmelzen kaum für zugänglich erachtete Pulver lassen sich mit Hilfe des erfindungsgemäßen Verfahrens ohne Probleme in den Schmelzzustand überführen.

Das Nachchargieren kann dabei grundsätzlich kontinuierlich oder portionsweise erfolgen. Wichtig ist jedoch in jedem Fall, die Menge des nachchargierten und des aufschmelzenden Materials so aufeinander abzustimmen, daß das pulverförmige Silicium nie direkt in geschmolzenes Material eingebracht wird, sondern stets zuerst auf eine dieser Schmelze übergelagerte Siliciumpulverschicht nachchargiert wird. Die aufschmelzende Menge läßt sich dabei beispielsweise durch die über Strahlungs-, Widerstands-oder Induktionsheizung in den Schmelztiegel eingespeiste Heizleistung steuern, während die Menge des nachchargierten Materials mit Hilfe geeigneter Dosiereinrichtungen z.B. Schüttelrinnen oder Förderschnecken dem Bedarf angepaßt werden kann.

Gemäß einer günstigen und bevorzugten Ausführungsform wird en Teil der im Tiegel erzeugten Siliciumschmelze am Tiegelboden in Form eines eine bestimmte Mindesthöhe aufweisenden Schmelzsees aufgefangen und lediglich die diese Mindesthöhe überschreitende Schmelzenmenge aus dem Tiegel abgeführt.

Die Mindestschmelzhöhe im Schmelztiegel wird zweckmäßig dadurch eingestellt, daß in dieser Höhe oberhalb des Bodenniveaus eine oder mehrere, das Ausfliessen der überschüssigen Schmelzmenge gestattende Abflußöffnungen vorgesehen werden. Vorzugsweise wird dazu in der Bodenfläche des Schmelztiegels ein die erforderliche Höhe aufweisender Siphon vorgesehen. Eine andere Möglichkeit besteht z.B. darin, in dieser Höhe nach dem Siphonprinzip in den Außenwänden des Tiegels eine oder mehrere, Auslaßöffnungen anzubringen.

Dabei kann die Mindestmenge des in geschmolzenem Zustand vorliegenden Materials gering gehalten werden. Obwohl grundsätzlich sogar niedrigere Werte möglich sind, wird bevorzugt eine Höhe des Schmelzsees von mindestens 1 mm, vorteilhaft zumindest 5 bis 15 mm vorgesehen. Diese Schmelzenhöhe reicht in der Regel aus, das allmählich nachrückende Siliciumpulver so zum Aufschmelzen zu bringen, daß nur geschmolzenes Material den Tiegel verläßt. Ohnehin ist die Gefahr gering, durch nachrückendes Pulver den Schmelzsee zum Erstarren zu bringen, da das chargierte Pulver während des Nachrückens immer heißere Zonen des Schmelztiegels durchläuft, so daß es kurz vor dem Eintauchen in den Schmelzsee schließlich nahezu Schmelztemperatur aufweist. Selbst im Falle eines Erstarrens kann in der Regel schon durch eine leichte Erhöhung der in die Schmelzzone einspeisten Heizleistung erneut ein Schmelzsee erzeugt werden.

Als Werkstoffe für die zur Durchführung des erfindungsgemäßen Verfahrens geeigneten Schmelztiegel lassen sich grundsätzlich die bekannten, gegenüber geschmolzenem Silicium inerten oder weitgehend inerten Tiegelmaterialien einsetzen, wie beispielsweise Quarz, Silciumcarbid oder Siliciumnitrid. Mit besonderem Vorteil wird Graphit verwendet, und zwar vorzugsweise in hochdichter oder z.B. durch Imporbeschichtung (Imprägnierung mit organischer Flüssigkeit und nachfolgende Zersetzung) oberflächenvergüteter Form. Wenn es die an das aufgeschmolzene Material gestellten Reinheitsanforderungen zulassen, lassen sich jedoch grundsätzlich auch andere hochtemperaturfeste Materialien wie beispielsweise Korund oder Aluminiumnitrid einsetzen, die ansonsten wegen der Kontaminationsgefahr vermieden werden.

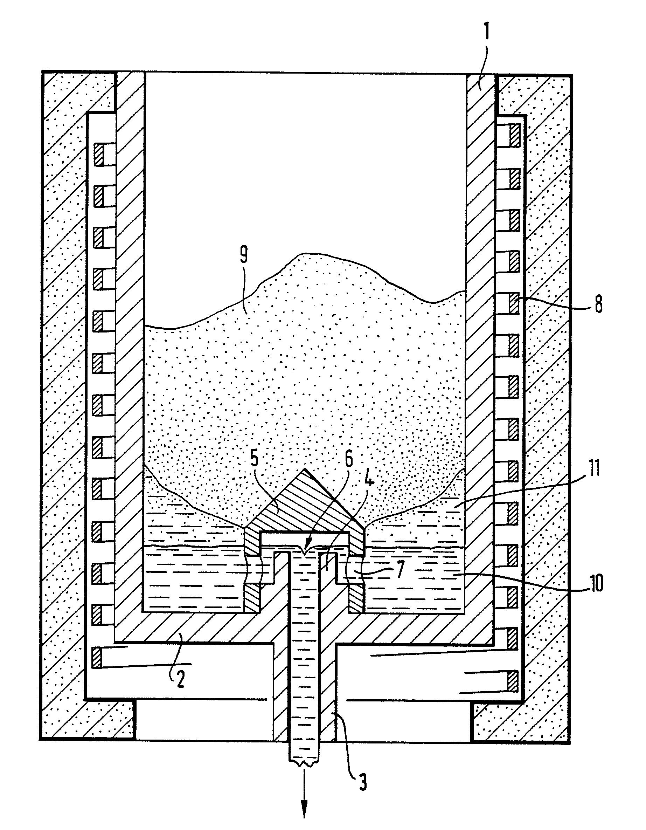

In der Figur ist ein mögliches Ausführungsbeispiel eines solchen Schmelztiegels dargestellt, an dem die Durchführung des erfindungsgemäßen Verfahrens näher erläutert wird.

Der beispielsweise hohlzylinderförmige Schmelztiegel 1 besitzt in seinem Tiegelboden 2 einen Abfluß 3, oberhalb dessen durch einen beispielsweise siphonartigen Aufsatz 4 ermöglichtwird, daß eine im Tiegel sich ausbildende geschmolzene Phase stets eine bestimmte Mindesthöhe aufweist. Vorteilhaft wird zusätzlich über dem Aufsatz 4 eine Abdeckung 5 vorgesehen, die die Abflußöffnung 6 von nachrückendem, nicht geschmolzenem Material frei hält. Durch die beispielsweise als Bohrungen oder Schlitze ausgebildeten Durchflüsse 7 der Abdeckung 5 gelangt geschmolzenes Material zur Abflußöffnung 6 und verläßt durch den Abfluß 3 den Tiegel. Der Schmelztiegel 1 ist zweckmäßig auf etwa 40 bis 100 % der Tiegelhöhe von einer Tiegelheizung 8 umgeben, welche ggf. verschiedene, vorteilhaft getrennt regelbare Heizzonen aufweist, um die dem Tiegelinhalt zugeführte Energiemenge steuern zu können und beispielsweise ein zu starkes Ansteigen der geschmolzenen Phase zu verhindern.

Das Aufschmelzverfahren kann erfindungsgemäß in der Weise eingeleitet werden, daß der kalte Schmelztiegel 1 bis zu einem Füll grad von in der Regel 30 bis 100 % mit Siliciumpulver 9 befüllt wird und danach auf die Arbeitstemperatur gebracht wird. Gleichermaßen kann auch das Siliciumpulver 9 in den bereits auf Arbeitstemperatur erhitzten Tiegel chargiert werden.

Das in der heißesten Zone des Schmelztiegels befindliche Siliciumpulver beginnt dabei allmählich aufzuschmelzen und bildet schließlich den Schmelzsee 10, der sich immer weiter auffüllt, bis er die durch die Abflußöffnung 6 vorgegebene Mindesthöhe erreicht hat. Oberhalb des Schmelzsees 10 bildet sich eine Anschmelzzone 11 aus, in der die Temperatur bereits im Bereich der Schmelztemperatur liegt, so daß einzelne Pulverteilchen oberflächlich anzuschmelzen beginnen und beim Kontakt mit dem Schmelzsee schließlich vollständig aufschmelzen. Die dabei entstehende überschüssige Schmelzmenge fließt durch die Abflußöffnung 6 und den Abfluß 3 aus dem Tiegel ab und kann einer Weiterbehandlung, beispielsweise einer gerichteten Erstarrung oder Vakuumausdampfung, unterzogen werden.

Entsprechend der Menge geschmolzenen Materials, die den Tiegel verläßt, kann auf die vorhandene Pulverschüttung weiteres aufzuschmelzendes Siliciumpulver nachchargiert werden. Dabei ist es jedoch nicht zwingend vorgeschrieben, die jeweils zu-und abgeführten Mengen streng aneinander anzupassenn; diese können vielmehr in weiten Grenzen variiert werden, sofern die Grenzfälle, nämlich entweder eine Überfüllung des Tiegels oder direktes Chargieren des Pulvers in den Schmelzsee, vermieden werden.

Eine elegante Art des Nachchargierens besteht darin, das Siliciumpulver über ein Tauchrohr aus beispielsweise Graphit, dessen Mündung in die Pulverschüttung im Tiegel eintaucht, einzubringen. Solange diese Mündung von Pulver bedeckt ist, wird das innerhalb des Tauchrohres nachfliessende Pulver zurückgehalten. Wenn das Pulverniveau im Tiegel soweit abgesunken ist, daß die Mündung des Tauchrohres frei wird, beginnt Pulver aus dem Rohrinnern nachzurieseln, und das Pulverniveau steigt, bis die Mündung wieder verschlossen ist. Anstelle eines solchen, gewissermaßen selbstregulierenden Systems kann z.B. auch eine Schüttelrinne eingesetzt werden, um das aufzuschmelzende Material kontinuierlich oder portionsweise in das Tiegelinnere einzubringen.

Der Füllstand des Tiegels läßt sich bei manchen Tiegelmaterialien, insbesondere bei Graphit, vorteilhaft optisch überwachen, da die Tiegelwandung,bzw. das Siliciumpulver ein deutlich unterschiedliches Glühverhalten zeigen. Diese Tatsache ermöglicht auch den Einsatz von berührungslosen Temperaturmeßgeräten wie Pyrometern zur Kontrolle des Füllstandes.

Bevorzugt wird, bei kontinuierlicher, konstanter Pulverzufuhr, der Schmelzvorgang und damit letztlich auch der Füllstand im Tiegel über die eingespeiste Heizleistung gesteuert. Grundsätzlich ist es jedoch auch möglich, bei konstanter Heizleistung die Pulverzufuhr zu variieren oder beide Kenngrößen variabel zu gestalten. Ohnehin ist die aus dem Tiegel in der Zeiteinheit abfließende Menge geschmolzenen Siliciums durch den Querschnitt des Abflusses nach oben hin begrenzt.

Mit fortschreitendem Aufschmelzen und Abfließen des im Bereich des Schmelzsees befindlichen Siliciumpulvers rückt das nachchargierte Siliciumpulver allmählich in immer heißere Zonen des Schmelztiegels vor. Dabei beginnt mit steigender Temperatur die oberflächliche Oxidhaut der Siliciumpartikel immer stärker in Form von flüchtigem Siliciummonoxid abzudampfen, so daß schließlich beim Eintauchen in den Schmelzsee das Material praktisch oxidfrei ist und ohne Störungen zum vollständigen Aufschmelzen gebracht werden kann.

Die Abflußöffnung und der Abfluß, durch welche das solchermaßen aufgeschmolzene Silicium schließlich den Schmelztiegel verläßt, brauchten nicht notwendig einen runden Querschnitt zu haben. Gleichermaßen geeignet sind polygenförmige, z.B. prismen-, quadrat-, pentagon-oder hexagonförmige aber auch schlitzförmige oder ovale Querschnitte. Des gilt auch für den diese Form bestimmenden, über das Niveau des Tiegelbodens hinausragenden Aufsatz (Siphon).

Gemäß einer bevorzugten Ausführungsform wird die Abflußöffnung mit einer Abdeckung versehen, die das Eindringen von nicht aufgeschmolzenem Material in den Abfluß verhindert. Günstig wird dabei eine nach oben spitz zulaufende Form gewählt, beispielsweise eine Kegel-, Pyramiden-oder Keilform, um das Entstehen von das Nachrücken der Pulververschüttung störenden Toträumen zu verhindern. Von Vorteil ist es auch, die Abdeckung beispielsweise durch Einpassen in entsprechende Ausnehmungen in der Bodenfläche des Tiegels oder durch Anpassen an die Basisfläche des Aufsatzes vor dem Verschieben durch nachrückendes Siliciumpulver zu sichern.

Das erfindungsgemäße Verfahren sowie die zu seiner Durchführung geeigneten Schmelztiegel gestatten es somit, selbst sehr feine Siliciumpulver kontinuierlich aufzuschmelzen. Da das Silicium stets nur in geringer Menge und nur für kurze Zeit innerhalb des Tiegels in geschmolzenem Zustand vorliegt, lassen sich sowohl die Energieverluste z.B. durch Abstrahlung als auch die Kontamination der Schmelze durch die Tiegelwandung gering halten. Außerdem können mit relativ kleinvolumigen Tiegeln große Mengen an Siliciumpulver aufgeschmolzen werden. Zweckmäßig wird das Verfahren in inerter Atmosphäre, bei Normal-oder reduziertem Druck, z.B. in Argonathmosphäre durchgeführt.

Ausführungsbeispiel:

Ein gemäß der Figur gestalteter, zylindrischer Schmelztiegel aus hochverdichtetem Graphit (Innendurchmesser ca. 110 mm, Innenhöhe ca. 240 mm, Wandstärke ca. 10 mm) besaß in seinem Boden einen Abfluß, dessen Abflußöffnung (Durchmesser ca. 10 mm) nach dem Siphonprinzip an der Oberseite eines Aufsatzes in Form eines abgestuften Graphitzylinders ca. 6 mm oberhalb des Niveaus des Tiegelbodens lag. Über den Aufsatz war eine die Abflußöffnung freihaltende, nach oben kegelförmig zulaufende Abdeckung gesteckt. Im 90°-Abstand waren in die Abdeckung Bohrungen (Durchmesser ca. 10 mm) eingearbeitet, die den Zutritt geschmolzenen Materials zu der Abflußöffnung gestatteten. Die Anordnung befand sich in einem evakuierten Rezipienten, in dem ein Argondruck von etwa 100 mbar eingestellt war.

Der Tiegel wurde mit Hilfe einer Schüttelrinne aus einem Siliciumreservoir zu etwa 70 % mit Siliciumpulver der mittleren Korngröße 20 μm befüllt. Nun wurde die Tiegelheizung eingeschaltet und der Tiegel erhitzt, bis aus dem Abfluß geschmolzenes Silicium abzulaufen begann. Daraufhin wurde die Heizleistung etwas zurückgefahren und mit Hilfe der Schüttelrinne kontinuierlich Siliciumpulver auf das im Schmelztiegel befindliche Pulver nachchargiert, so daß die über ein Schauglas im Rezipienten beobachtbare Schütthöhe im Schmelztiegel etwa konstant blieb. Das abfließende geschmolzene Silicium wurde in einem geeigneten Gefäß aufgefangen.

Nach diesem Verfahren und mit Hilfe des angegebenen Schmelztiegels gelang es, innerhalb einer Stunde eine Menge von ca. 30 kg Siliciumpulver der mittleren Korngröße 20 μm zu erschmelzen.

**Ansprüche**

1. Verfahren zum Aufschmelzen von in einen Schmelztiegel chargiertem Siliciumpulver, **dadurch gekennzeichnet,** daß die im Schmelztiegel vorgelegte Pulverschüttung während des Schmelzvorganges stets von einer Schicht nicht angeschmolzenen Siliciumpulvers bedeckt gehalten wird, wobei weiteres Siliciumpulver kontinuierlich oder taktweise auf die vorhandene Schicht nicht angeschmolzenen Siliciumpulvers nachchargiert wird, während nur die durch den in die Schmelzzone nachrückenden Teil der Pulverschüttung erzeugte Siliciumschmelze aus dem Tiegel abgeführt wird.

2. Verfahren nach Anspruch 1, **dadurch gekennzeichnet,** daß ein Teil der erzeugten Siliciumschmelze in Form eines eine bestimmte Mindesthöhe aufweisenden Schmelzsees am Tiegelboden aufgefangen und lediglich die diese Mindesthöhe überschreitende Schmelzenmenge aus dem Tiegel abgeführt wird.

3. Verfahren nach Anspruch 2 , **dadurch gekennzeichnet,** daß die Höhe des Schmelzsees mindestens 1 mm beträgt.

4. Verfahren nach den Ansprüchen 1 bis 3 , **dadurch gekennzeichnet,** daß Siliciumpulver mit einem Feinkornanteil eingesetzt wird, der ein Sieb mit einer Maschenweite von etwa 1 mm passiert und dessen Anteil an der gesamten Si-Menge mindestens 1 Gew.-% beträgt.

5. Schmelztiegel zur Durchführung des Verfahrens nach einem oder mehreren der Ansprüche 1 bis 4 , **gekennzeichnet durch** mindestens eine oberhalb des Bodenniveaus liegende, die Ausbildung eines eine konstante Mindesthöhe aufweisenden Schmelzsees gestattende Abflußöffnung.

6. Schmelztiegel nach Anspruch 5, **dadurch gekennzeichnet,** daß die Abflußöffnung durch einen das Bodenniveau überragenden Siphon gebildet wird.

7. Schmelztiegel nach den Ansprüchen 4 bis 6 , **dadurch gekennzeichnet,** daß die Abflußöffnung zusätzlich mit einer den Austritt von pulverförmigem Silicium verhindernden Abdeckung versehen wird.